## Europäisches Patentamt
## European Patent Office
## Office européen des brevets

(19)

(11) Veröffentlichungsnummer: **0 094 528**

**A2**

# (12) EUROPÄISCHE PATENTANMELDUNG

(21) Anmeldenummer: 83104121.5

(22) Anmeldetag: 27.04.83

(51) Int. Cl.³: **H 01 L 21/28**
**H 01 L 21/90**

(30) Priorität: 05.05.82 DE 3216823

(43) Veröffentlichungstag der Anmeldung:
23.11.83 Patentblatt 83/47

(84) Benannte Vertragsstaaten:
DE FR GB

(71) Anmelder: **SIEMENS AKTIENGESELLSCHAFT**
**Berlin und München Wittelsbacherplatz 2**
**D-8000 München 2(DE)**

(72) Erfinder: **Beinvogl, Willy, Dr.**
**Tutzinger Strasse 3**
**D-8000 München 70(DE)**

(54) Verfahren zum Herstellen von Strukturen von aus Metallsilizid und Polysilizium bestehenden Doppelschichten auf integrierte Halbleiterschaltungen enthaltenden Substraten durch reaktives Ionenätzen.

(57) Die Erfindung betrifft ein Verfahren zum Herstellen von Strukturen von aus Metallsilizid (4) und Polysilizium (3) bestehenden Doppelschichten auf integrierte Halbleiterschaltungen enthaltenden Siliziumsubstraten (1) durch reaktives Ionenätzen unter Verwendung einer Fotolackmaske (5), bei dem in einem Plattenreaktor als reaktives Gas ein Gasgemisch verwendet wird, das Fluor und Chlor enthält. Die Doppelschicht (3, 4) besteht vorzugsweise aus einer Tantalsilizid/Polysiliziumschicht. Das Verfahren wird insbesondere verwendet für die Herstellung niederohmiger Leiterbahnen in VLSI-Schaltungen.

FIG 2

SIEMENS AKTIENGESELLSCHAFT          Unser Zeichen
Berlin und München                  VPA 82 P 1 3 72 E


Verfahren zum Herstellen von Strukturen von aus Metallsilizid und Polysilizium bestehenden Doppelschichten auf
integrierte Halbleiterschaltungen enthaltenden
Substraten durch reaktives Ionenätzen.


Die Erfindung betrifft ein Verfahren zum Herstellen von
Strukturen von aus Metallsilizid/Polysilizium bestehenden Doppelschichten (auch Polyzid genannt) auf integrierte Halbleiterschaltungen enthaltenden, vorzugsweise
mit einer Isolationsschicht versehenen Siliziumsubstraten durch reaktives Ionenätzen in einem Plattenreaktor mit einem Halogene enthaltenden Gasgemisch unter
Verwendung einer Fotolackmaske.


Metallsilizide finden bei der Herstellung von hochintegrierten MOS-Schaltungen zunehmende Bedeutung. Eine
der möglichen Anwendungen ist ihre Verwendung als
niederohmiges Leitbahn- und Gatematerial in einem Poly-
silizium-Gate-Prozeß. Das bewährte Polysilizium wird dabei im allgemeinen nicht durch das Silizid ersetzt, sondern ergänzt, und zwar in der Form, daß man über einer
dotierten Polysiliziumschicht das Silizid aufbringt. Die
Erzeugung feiner Strukturen in solchen Doppelschichten
ist ein komplexes Ätzproblem, da bei der Herstellung von
integrierten Schaltungen eine Reihe von Randbedingungen
zu beachten sind.


Die Lösung dieses komplexen Ätzproblems ist Aufgabe der
vorliegenden Erfindung.


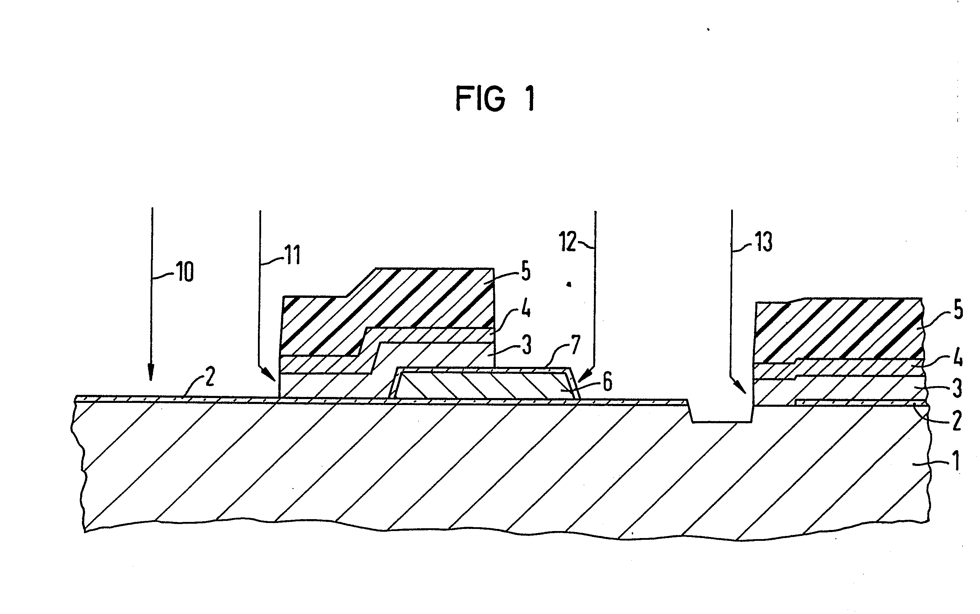

Anhand der in der Zeichnung abgebildeten Figur 1 sollen
die Randbedingungen, die beim Ätzprozeß bei der Her-


Edt 1 Plr/27.4.1982

stellung einer integrierten Schaltung beachtet werden müssen, näher erläutert werden. Dabei ist mit dem Bezugszeichen 1 das Siliziumsubstrat, mit 2 die darauf befindliche $SiO_2$-Schicht, mit 3 die $n^+$-dotierte Polysiliziumschicht, mit 4 die Silizidschicht, mit 5 die als Ätzmaske dienende Fotolackschicht, mit 6 die Poly-Silizium-1-Gatestruktur und mit 7 das darauf befindliche Isolationsoxid bezeichnet. In allen Figuren der vorliegenden Patentanmeldungen gelten für gleiche Teile gleiche Bezugszeichen. Die in Figur 1 eingezeichneten senkrechten Pfeile zeigen jeweils das Ätzproblem an, das durch das Verfahren nach der Lehre der Erfindung gelöst werden soll.

So zeigt der Pfeil 10 die angestrebte hohe Selektivität zu $SiO_2$ (2) oder einem anderen entsprechenden Isolatormaterial. Das Schichtdickenverhältnis Poly-zid-Doppelschicht (3, 4) : $SiO_2$ (2) beträgt bis zu 20:1.

Der Pfeil 11 zeigt die Erzielung einer geeigneten Kantenform in den geätzten Strukturen. Dies kann entweder durch anisotropes Ätzen mit senkrechten Kanten, wie dargestellt, oder durch abgeschrägtes Ätzen erfolgen.

Der Pfeil 12 soll das Stufenproblem in einem Doppel-Poly-Silizium-Gateprozeß mit der Gefahr von elektrischen Kurzschlüssen durch Ätzrückstände an Polysilizium 1-Kanten (6, 7) andeuten.

Der Pfeil 13 weist auf die Ausbildung des Kontaktes Polyzid (3, 4) zum Substrat (1), dem sogenannten buried contact hin.

Neben diesen Bedingungen, die durch das erfindungsgemäße Verfahren zu erfüllen sind, hat die Erfindung noch die Aufgabe, daß als Ätzmaske eine Fotolackmaske verwendbar sein soll, welche durch den Ätzprozeß nicht angegriffen wird. Außerdem soll in allen Bereichen, wegen des sogenannten Kurzkanaleffektes, eine hohe Ätzgleichmäßigkeit vorhanden sein.

Aus dem Stand der Technik ist bekannt, Strukturen von Polysiliziden zu ätzen, wobei in fast allen bekannten Fällen Molybdän- und Wolframsilizide geätzt werden. Über die Ätzung von Tantalsilizidstrukturen, welches gegenüber Molybdän- und Wolframsiliziden wegen der besseren Temperaturstabilität bei hohen Temperaturen und der guten Hafteigenschaften auf Polysilizium erhebliche Vorteile hat, gibt es nur einen kurzen Hinweis in J. Vac. Sci. Technol. 17 (4) July/Aug.1980 p.787/788, aus dem zu entnehmen ist, daß Titan-, Tantal-, Molybdän- und Wolfram-Silizide im Plasma in einer Tetrafluor-Kohlenstoff-Sauerstoff-Mischung zu ätzen sind. Dabei werden die Ätzungen teils im Tunnelreaktor, teils im Parallelplattenreaktor in anodischer Kopplung ("Plasmaätzen") durchgeführt (siehe auch J. Vac. Sci. Technol. 18 (2) March 1981, p. 346). Im Prinzip können diese Schichten auch naß geätzt werden, jedoch nur mit dem für Naßätzung üblichen Maßverlust.

Aus der europäischen Patentanmeldung 0 015 403 sind mehrere Verfahren zum Plasmaätzen von Polysilizium zu entnehmen, wobei von Gasmischungen bestehend aus Schwefelhexafluorid ($SF_6$), Chlor ($Cl_2$) und einem Inertgas ausgegangen wird. Bei diesen Verfahren wird aber nur Silizium selektiv geätzt, wobei eine sehr gute Selektivität in Gegenwart von $SiO_2$ und Siliziumnitrid erzielt wird. Daneben wird auch, bedingt durch das reaktive Ionenätzen (die zu ätzenden Substrate werden auf die HF-führende Elektrode gelegt) eine gerichtete Ätzung durchgeführt, so daß die erzeugten Vertiefungen senkrechte Seitenwände haben und die Ätzmaske über den Rand der geätzten Vertiefungen nicht hinausragt.

Ein Verfahren der eingangs genannten Art ist in der Patentanmeldung P 30 45 922.4 vorgeschlagen worden. Bei diesem Verfahren wird Schwefelhexafluorid als Ätzgas verwendet und der Ätzprozeß in zwei Schritten mit unterschiedlichen Ätzraten durchgeführt. Auch bei diesem Ätzprozeß wird eine strenge Anisotropie angestrebt.

Das Verfahren nach der Lehre der Erfindung geht über diesen Stand der Technik für die Ätzung einer Metall-silizid/Polysilizium-Doppelschicht (genannt Polyzid-Schicht) hinaus und löst auch noch das Problem der abgeschrägten Ätzung bzw. das Stufenproblem in einem Doppel-Poly-Silizium-Gateprozeß ohne die Gefahr von elektrischen Kurzschlüssen benachbarter Polyzidbahnen (siehe Figur 1, Pfeile 11, 12 und 13).

Das Verfahren nach der Lehre der Erfindung ist dadurch gekennzeichnet, daß als reaktives Gas ein Gasgemisch verwendet wird, welches Fluor und Chlor enthält. Würde man nur ein Fluor enthaltendes Ätzgas wie Schwefelhexafluorid verwenden, so würde sich ein Überhang ausbilden. Andererseits bringt die Verwendung von nur Chlor als Ätzgas, insbesondere bei Tantalsilizidschichten sehr niedrige Ätzraten. Es liegt daher im Rahmen der Erfindung, eine aus Schwefelhexa-fluorid ($SF_6$) und Chlor ($Cl_2$) bestehende Gasmischung zu verwenden.

Es ist aber auch möglich, durch Chloratome substituierte Fluorkohlenwasserstoffe, wie Monochlortrifluormethan ($CClF_3$) oder Dichlordifluormethan ($CCl_2F_2$) einzusetzen.

Gemäß einem besonders günstigen Ausführungsbeispiel nach der Lehre der Erfindung wird eine Doppelschicht verwendet, welche aus einer etwa 200 nm dicken Tantalsilizidschicht, wobei das Tantal:Silizium-Verhältnis wie 1:2 ist, und aus einer 300 nm dicken $n^+$-dotierten Polysiliziumschicht besteht.

Andere Ausgestaltungen der Erfindung ergeben sich aus den Unteransprüchen.

Weitere Einzelheiten sowie Vorteile des erfindungsgemäßen Verfahrens werden im folgenden anhand von Ausführungsbeispielen und der Figuren 2 bis 8 noch näher erläutert. Dabei zeigt

die Figur 2 im Schnittbild eine gemäß der Lehre der Erfindung hergestellte Struktur,

die Figuren 3, 4 und 5 in einem Diagramm die optimalen Ätzbedingungen (Mischungsverhältnis der Gase, Ätzzeit, Gasdruck und HF-Leistung) mit den dabei erzielten Strukturen,

die Figuren 6 und 7 die mit unterschiedlichem Volumenverhältnis (aktives Volumen : Reaktorvolumen) erhaltenen Strukturen und

die Figur 8 das Ätzratenverhältnis $n^+$-dotiertes Polysilizium zu einkristallinem Silizium bzw. die Selektivität Polysilizium zu $SiO_2$ in Abhängigkeit von der Gasmischung.

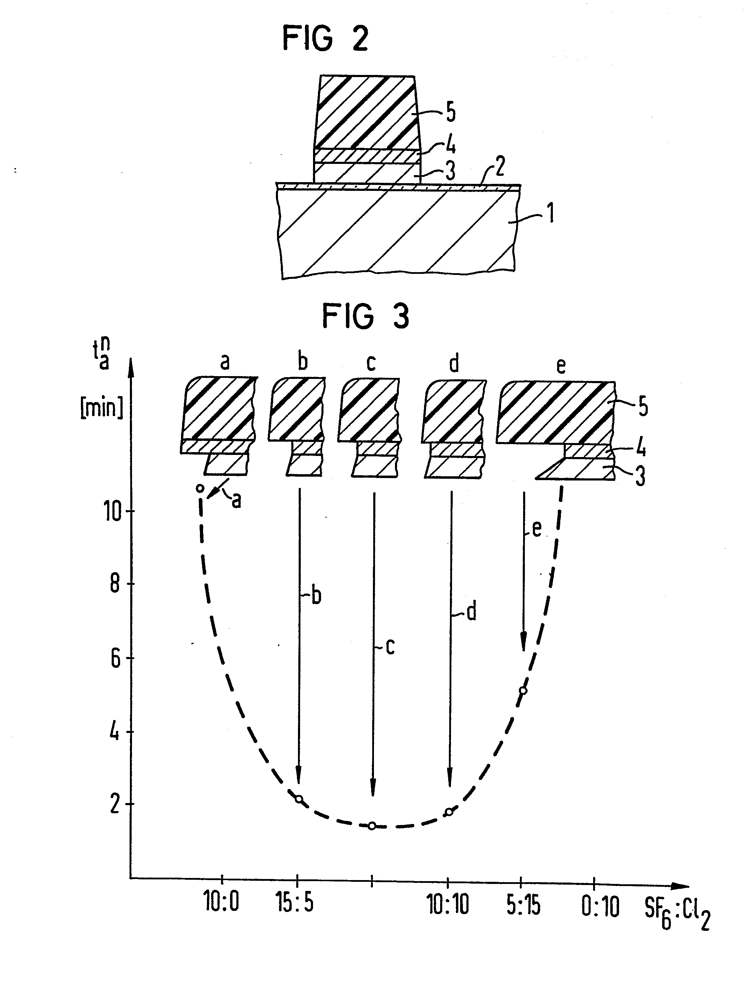

Die in Figur 2 dargestellte Struktur besteht aus einer 300 nm dicken, auf einem mit einem 20 nm dicken $SiO_2$-Schicht 2 versehenen Siliziumsubstrat 1 aufgebrachten $n^+$-dotierten (Phosphor oder Arsen) Polysiliziumschicht 3 und einer darüber abgeschiedenen 200 nm dicken Tantalsilizidschicht 4. Mit 5 ist die als Ätzmaske verwendete Photolackschicht bezeichnet. Das Tantal:Silizium-Verhältnis beträgt ungefähr 1:2 (Schwankungen des Ta:Si-Verhältnisses sind zugelassen bei 30 % - 50 % Ta). In Figur 2 ist eine Struktur abgebildet, bei der ein strikt anisotropes Ätzen angestrebt wurde. Dies kann z. B. durch einen Zweistufenprozeß erreicht werden, indem zunächst das Tantalsilizid (4) mit geringem Chloranteil im Ätzgas geätzt und anschließend das Polysilizium (3) in reinem Chlor behandelt wird. Auf diese Weise können Silizid-Polysilizium-Doppelschichten völlig unterätzungsfrei mit senkrechten Kanten, wie in Figur 2 dargestellt, erhalten werden. Der Umschaltpunkt von der ersten zur zweiten Stufe kann z. B. durch Aufzeichnung der Intensität einer geeigneten Emissionslinie des Plasmas festgelegt werden. Gleichzeitig kann man in der zweiten Stufe (mit reinem $Cl_2$) eine sehr hohe Selektivität Poly-Si zu $SiO_2$ von $> 30:1$ erreichen.

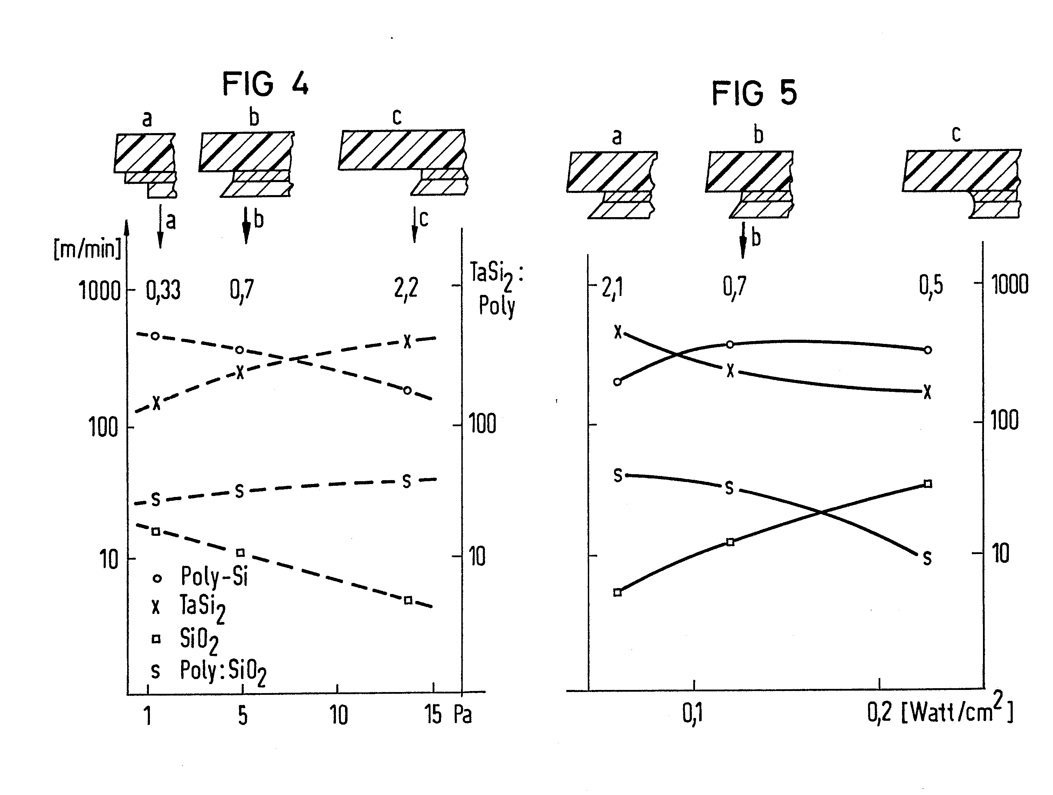

Aus Figur 3 ist ersichtlich, wie sich die Kantenprofile der Doppelschicht 3, 4 mit der Zusammensetzung der Ätzgasmischung ändern. Dabei ist als Abszisse das Mischungsverhältnis $SF_6:Cl_2$ und als Ordinate die Ätzzeit $t_a^n$ für die Doppelschicht aufgetragen. Die in die Figur eingezeichnete gestrichelte Kurve zeigt die Abhängigkeit der Ätzzeit von der Gaszusammensetzung. Die Struktur a zeigt eine ohne Chloranteile geätzte Struktur mit hoher Ätzzeit (siehe Pfeil a). Die Struktur b hat eine sehr niedrige Ätzzeit (siehe Pfeil b). Die Struktur c hat die niedrigste Ätzzeit bei einem Gasmischungsverhältnis von $SF_6:Cl_2$ = 2:1. Die Struktur c ist zwar deutlich unterätzt, ist aber vom Profil her brauchbar. Die Struktur e wurde mit einem Mischungsverhältnis $SF_6:Cl_2$ = 5:15 erzielt. In diesem Fall unterätzt das Silizid sehr stark. Eine wesentlich bessere Anisotropie für das Mischungsverhältnis $SF_6:Cl_2$ = 5:15 würde man mit niedrigerem Druck ($\sim$10 mTorr = 1,5 Pa) erhalten.

Der Gasdruck im Reaktor betrug bei den Ätzungen in Figur 3 6 bis 9 Pa (= 40 bis 60 mTorr), die HF-Leistung $\sim$0.12 $W/cm^2$.

0094528

In den Figuren 4 und 5 ist die Ätzgeschwindigkeit in nm/min in Abhängigkeit vom Gasdruck in Pa (Figur 4) und der HF-Leistung in Watt/cm$^2$ (Figur 5) aufgetragen. Die Pfeile markieren die Bedingungen, unter denen die eingezeichneten Strukturen erhalten wurden. Die Pfeile für die Strukturen mit den günstigsten Bedingungen sind stärker ausgezeichnet. Bei dem in Figur 4 dargestellten Diagramm wurde eine HF-Leistung von 0,1 W/cm$^2$ eingestellt. Die Gasmischung hatte ein Mischungsverhältnis $SF_6:Cl_2:He$ (Helium) = 12,5:6,5:20. Die x-gestrichelte Kurve gilt für Tantalsilizid, die o-gestrichelte Kurve für Polysilizium, die □ -gestrichelte Kurve für $SiO_2$ und die mit S-gestrichelte Kurve zeigt die Selektivitäten von Polysilizium : $SiO_2$.

Das gleiche gilt auch für das in Figur 5 eingezeichnete Kurvendiagramm, welches die Abhängigkeit von der HF-Leistung (Watt/cm$^2$) darstellt. Der Gasdruck im Reaktor betrug 40 mTorr.

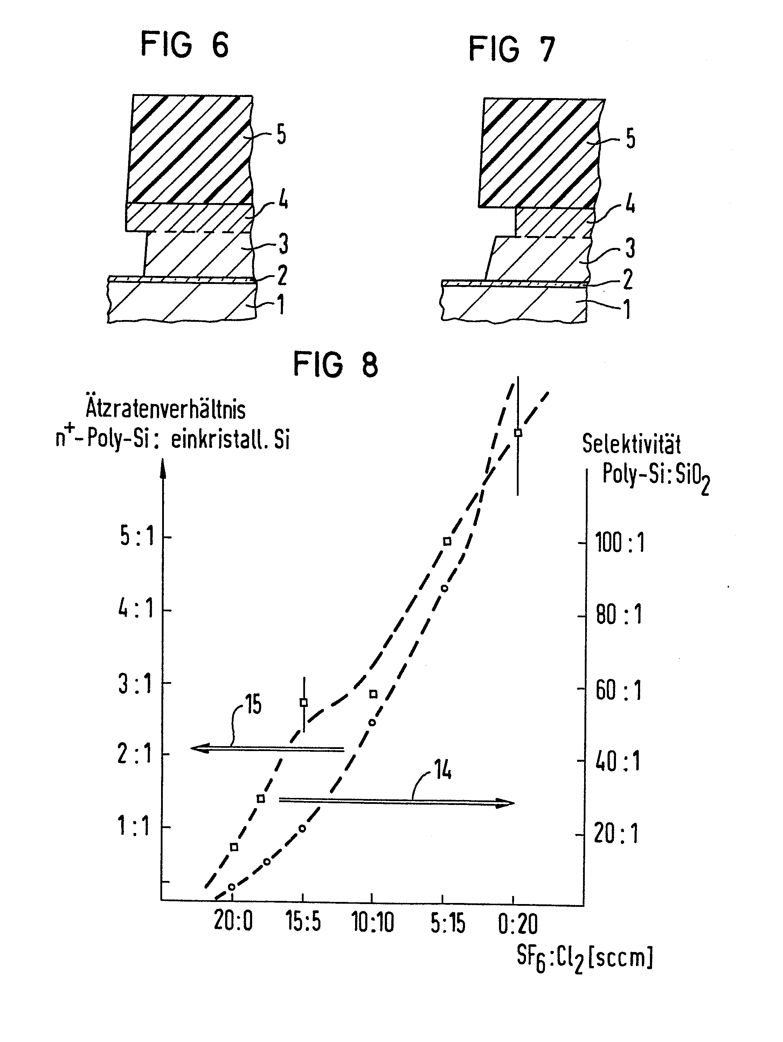

Figur 6 und 7: Es wurde festgestellt, daß bei konstanter Gasmischung das Ätzprofil empfindlich auch von der Reaktorgeometrie abhängt, das heißt vom Verhältnis aktives oder Plasmavolumen zu Gesamtvolumen des Reaktors. Das Verhältnis beeinflußt die Konzentrationsverteilung der verschiedenen Radikale im Plasma. Bei der in Figur 6 abgbildeten Struktur lag ein Verhältnis des aktiven Volumens zum Reaktorvolumen von < 1:20 vor, während bei Figur 7 das Verhältnis etwa 1:2 betrug, das heißt, das aktive Volumen entsprach der Hälfte des Reaktorvolumens. Der wesentliche Unterschied besteht darin, daß im ersten Fall das Silizid (die obere Schicht) bei allen $SF_6:Cl_2$-Verhältnissen anisotrop bezüglich der Fotolackmaske ätzt. Im zweiten Fall kann man über das Mischungsverhältnis das Silizidätzverhalten von anisotrop bis zu starkem Unterätzen variieren (s. Figur 3).

Figur 8: Wenn die Polyzidschicht (3, 4) lokal einen Kontakt zum Siliziumsubstrat (buried contact) haben soll, ist naturgemäß ein gewisses Anätzen des Substrats (1) nicht zu vermeiden (siehe Figur 1, Pfeil 13). Dies kann am Ende des Herstellungsprozesses einer Schaltung zu erhöhten Übergangswiderständen zwischen Polyzid und Substrat führen. Bei richtiger Wahl des Fluor-Chlor-Verhältnisses im Reaktionsgas kann man eine relativ hohe (bis zu 10:1) Selektivität von $n^+$-Polysilizium:Siliziumsubstrat erreichen und damit das Anätzen des Substrats sehr gering halten. Diese Verhältnisse sind aus Figur 8 zu entnehmen. Das Diagramm zeigt das Ätzratenverhältnis $n^+$-Polysilizium : einkristallines Silizium bzw. die Selektivität $n^+$-Polysilizium : $SiO_2$ in Abhängigkeit vom Gasmischungsverhältnis $SF_6:Cl_2$ in sccm (= standard-cm$^3$ pro min, dabei bedeutet Standard bei atmosphärischem Druck und definierter Temperatur). Die mit dem Pfeil 14 gekennzeichnete Kurve gilt für die Selektivität, die mit dem Pfeil 15 für das Ätzgeschwindigkeitsverhältnis. Die eingezeichneten Markierungen stellen Meßpunkte dar. Der günstigste Bereich liegt bei einem Gasmischungsverhältnis $SF_6:Cl_2$ zwischen 5:15 und 2:18.

Es liegt im Rahmen des Erfindungsgedankens, das Strukturieren des Polyzids (3, 4) vor dem Tempern, durch welches das Silizid polykristallin und niederohmig gemacht wird, durchzuführen. Vor dem Tempern ist die Grenzfläche Silizid/Polysiliziumschicht sehr viel homogener, das heißt weniger rauh als nach dem Tempern. Dies hat den Vorteil, daß der Umschaltpunkt beim Ätzen in einem Zweistufenprozeß besser zu definieren ist.

11 Patentansprüche
8 Figuren

Patentansprüche

1. Verfahren zum Herstellen von Strukturen von aus Metallsilizid/Polysilizium bestehenden Doppelschichten (3, 4) auf integrierte Halbleiterschaltungen enthaltenden, vorzugsweise mit einer Isolationsschicht (2) versehenen Siliziumsubstraten (1) durch reaktives Ionenätzen in einem Plattenreaktor mit einem Halogene enthaltenden Gasgemisch unter Verwendung einer Fotolackmaske (5), d a d u r c h   g e k e n n z e i c h n e t daß als reaktives Gas ein Gasgemisch verwendet wird, das Fluor und Chlor enthält.

2. Verfahren nach Anspruch 1, d a d u r c h   g e k e n n z e i c h n e t , daß als reaktives Gas eine aus Schwefelhexafluorid ($SF_6$) und Chlor ($Cl_2$) bestehende Gasmischung verwendet wird.

3. Verfahren nach Anspruch 1, d a d u r c h   g e - k e n n z e i c h n e t , daß ein durch Chloratome substituierter Fluorkohlenwasserstoff wie Monochlortrifluormethan oder Dichlordifluormethan verwendet wird.

4. Verfahren nach Anspruch 1 bis 3, d a d u r c h   g e k e n n z e i c h n e t , daß eine aus Tantalsilizid ($TaSi_2$) und Polysilizium bestehende Doppelschicht (3, 4) verwendet wird.

5. Verfahren nach Anspruch 4, d a d u r c h   g e - k e n n z e i c h n e t , daß die Doppelschicht (3, 4) aus einer 200 nm dicken Tantalsilizidschicht (4), wobei das Tantal:Silizium-Verhältnis 1:2 ist, und aus einer 300 nm dicken $n^+$-dotierten Polysiliziumschicht (3) besteht.

6. Verfahren nch Anspruch 4 und 5, d a d u r c h   g e k e n n z e i c h n e t , daß zur Erzielung eines Unterätzeffektes bei Verwendung eines aus Schwefelhexafluorid und Chlor bestehenden Gasgemisches das Mischungsvrhältnis $SF_6:Cl_2$ auf 2:1 eingestellt, der Druck auf 6 - 9 Pa und die HF-Leistung des Reaktors auf 0.1 bis 0.14 $W/cm^2$ eingestellt wird.

7. Verfahren nach Anspruch 4 und 5, d a d u r c h g e k e n n z e i c h n e t , daß zur Erzielung eines anisotropen Ätzabtrags bei Verwendung eines aus Schwefelhexafluorid und Chlor bestehenden Gasgemisches der Ätzprozeß in zwei Stufen durchgeführt wird, wobei zunächst die Tantalsilizidschicht (4) mit dem Schwefelhexafluorid-Chlor-Gasgemisch im Mischungsverhältnis größer 3:1 geätzt wird und anschließend die Polysiliziumschicht (3) mit reinem Chlor geätzt wird.

8. Verfahren nach Anspruch 1 bis 7, d a d u r c h g e k e n n z e i c h n e t , daß zur Erzeugung von Unterätzungen in der Polysiliziumschicht (3) das Verhältnis des Reaktionsgasvolumens im Reaktor zu dem Reaktorvolumen auf kleiner 1:20 bei einem Mischungsverhältnis von Schwefelhexafluorid:Chlor von 1:1 eingestellt wird.

9. Verfahren nach Anspruch 1 bis 7, d a d u r c h g e k e n n z e i c h n e t , daß zur Erzeugung von Unterätzungen in der Tantalsilizidschicht (4) das Verhältnis des aktiven Reaktionsvolumens im Reaktor zum Reaktorvolumen auf 1:2 bei einem Mischungsverhältnis von Schwefelhexafluorid : Chlor von 1:1 eingestellt wird.

10. Verfahren nach Anspruch 1 bis 9, d a d u r c h g e k e n n z e i c h n e t , daß das reaktive Ionenätzen vor dem zur Überführung der aus Metalsilizid/ Polysilizium bestehenden Doppelschicht (3, 4) in den kristallinen Zustand erforderlichen Temperprozeß durchgeführt wird.

11. Verfahren nach Anspruch 1 bis 10, d a d u r c h g e k e n n z e i c h n e t , daß ein Trägergas, vorzugsweise ein Edelgas wie Helium, verwendet wird.

# FIG 1

1/4

0094528

0094528

# FIG 2

5
4
3
2
1

# FIG 3

$t_a^n$

[min]

a  b  c  d  e

5
4
3

10

8

6

4

2

a
b
c
d
e

10:0   15:5   10:10   5:15   0:10   $SF_6:Cl_2$

FIG 5

FIG 4

## FIG 6

## FIG 7

## FIG 8

Ätzratenverhältnis
$n^+$-Poly-Si : einkristall. Si

Selektivität
Poly-Si:SiO$_2$

5:1

4:1

3:1

2:1

1:1

15

14

100:1

80:1

60:1

40:1

20:1

20:0   15:5   10:10   5:15   0:20

SF$_6$:Cl$_2$ [sccm]